# EUROPÄISCHE PATENTSCHRIFT

(11) **EP 3 221 490 B1**
(45) Veröffentlichungstag und Bekanntmachung des Hinweises auf die Patenterteilung: **04.03.2020**
(21) Anmeldenummer: 15800749.2
(22) Anmeldetag: 18.11.2015
(51) Int. Cl.: C23C 16/54, B01J 3/03, C23C 14/12, C23C 14/56, B01J 3/02, C23C 16/52

(54) **CVD- ODER PVD-REAKTOR ZUM BESCHICHTEN GROSSFLÄCHIGER SUBSTRATE**
CVD OR PVD REACTOR FOR COATING LARGE-AREA SUBSTRATES
RÉACTEUR CVD OU PVD POUR REVÊTIR DES SUBSTRATS DE SURFACE IMPORTANTE

(30) Priorität: 20.11.2014 DE 102014116991
(43) Veröffentlichungstag der Anmeldung: 27.09.2017
(73) Patentinhaber: Aixtron SE, 52134 Herzogenrath (DE)
(72) Erfinder: FRANKEN, Walter, 52249 Eschweiler (DE); ZINTZEN, Bernhard, 52078 Aachen (DE); JANSSEN, Henricus Wilhelmus Aloysius, 5845 BL Sint Anthonis (NL)
(74) Vertreter: Grundmann, Dirk
(86) Internationale Anmeldenummer: PCT/EP2015/076972
(87) Internationale Veröffentlichungsnummer: WO 2016/079184

(56) Entgegenhaltungen:
- DE-A1- 2 361 744
- US-A1- 2008 050 536
- US-A1- 2008 317 973
- US-A1- 2009 095 220

## Beschreibung

Die Erfindung betrifft eine CVD- oder PVD-Beschichtungseinrichtung mit einem Gehäuse und einem am Gehäuse befestigten Gaseinlassorgan mit einer Gasaustrittsöffnungen aufweisenden Gasaustrittsfläche, mit einer an einem oberen Abschnitt des Gehäuses befestigten Halteeinrichtung, an welcher das Gaseinlassorgan an einer Vielzahl von Aufhängestellen befestigt ist.

Eine gattungsgemäße Beschichtungsreinrichtung beschreibt die EP 1 815 493 B1, die ein Gehäuse einer Beschichtungseinrichtung zeigt, in der eine Halteeinrichtung angeordnet ist, die ein Gaseinlassorgan hält. Eine ähnliche Vorrichtung wird in der US 2008/0317973 A1 beschrieben.

Die DE 2361744 A beschreibt ein Gaseinlassorgan für einen CVD-Reaktor, bei dem unter einer mit einer Heizung versehenen Gasversorgungseinrichtung das Gaseinlassorgan sitzt. Das Prozessgas wird durch Röhrchen hindurch zu einer Gasauslassöffnung transportiert. Die Röhrchen bilden die Halteelemente, mit denen das Gaseinlassorgan an einer Gasversorgungseinrichtung befestigt ist.

Die US 2009/0250008 A1 beschreibt ebenfalls einen CVD-Reaktor. Ein Showerhead besitzt eine Gasaustrittsfläche, die von einer Gasaustrittsplatte gebildet ist. Am Rand der Gasaustrittsplatte ist ein ringförmiger Körper mit einem Kanal vorgesehen, durch den ein Kühlmittel fließen kann. Es sind zudem Heizelemente vorgesehen, mit denen der ringförmige Körper aufgeheizt werden kann.

Eine gattungsgemäße Beschichtungseinrichtung besitzt einen Suszeptor zur Aufnahme des zu beschichtenden Substrates und ein die Funktion eines Gasverteilers ausübendes Gaseinlassorgan, mit dem Prozessgase in eine Prozesskammer einleitbar sind, die sich zwischen einer Unterseite des Gasverteilers und dem Suszeptor erstreckt. Der Gasverteiler besitzt an seiner Unterseite eine Vielzahl von Gasaustrittsöffnungen, durch die das Prozessgas in die Prozesskammer eintreten kann. Innerhalb des Gasverteilers befinden sich Kammern zur Verteilung des Prozessgases an die Gasaustrittsöffnungen. Ein Gasverteiler dieser Art wird beispielsweise in der DE 10 2013101534 A1 beschrieben.

Zur Abscheidung von OLEDs werden in einem beheizten Gasverteiler gasförmige organische Ausgangsstoffe mit Hilfe eines Trägergases eingespeist. Diese gasförmigen Ausgangsstoffe treten durch die Gasaustrittsöffnungen in die Prozesskammer ein, um auf einem Substrat zu kondensieren, was hierzu auf dem gekühlten Suszeptor aufliegt. Die Substrate können eine Oberfläche von mehr als 1 m² besitzen. Es besteht eine Anforderung dahingehend, CVD- oder PVD-Reaktoren mit einer Suszeptordiagonalen von 2 m bis 3 m herzustellen. Da sich das Gaseinlassorgan über die gesamte Fläche des Suszeptors erstrecken muss, besteht das Bedürfnis, ein Gaseinlassorgan mit einer Diagonalen von 2 m bis 3 m zu schaffen. Die Prozesskammer besitzt eine Prozesskammerhöhe von wenigen Zentimetern. Um über die gesamte Substratoberfläche eine Schicht gleichbleibender Schichtdicke und gleichbleibender Schichtqualität abscheiden zu können, ist es erforderlich, dass die Prozesskammerhöhe innerhalb enger Toleranzen über die gesamte Prozesskammer einen konstanten Wert einnimmt. Der Abscheideprozess findet im Niedrigdruckbereich statt, also in einem Bereich, in dem der Atmosphärendruck die Gehäusewände mit erheblichen Verformungskräften beaufschlagt. Es ist nicht zu vermeiden, dass sich das Gehäuse beim Absenken des Drucks verformt. Darüber hinaus wird das Gaseinlassorgan beheizt, so dass zusätzlich zu den mechanischen Kräften thermische Ausdehnungsphänomene zu berücksichtigen sind.

Der Erfindung liegt die Aufgabe zugrunde, eine gattungsgemäße Beschichtungseinrichtung derart weiterzubilden, dass die Prozesskammerhöhe über die gesamte Fläche des Suszeptors bzw. der Gasaustrittsfläche des Gaseinlassorgans nur in engen Toleranzen variiert.

Gelöst wird die Aufgabe durch die in den Ansprüchen angegebene Erfindung, wobei jeder Anspruch grundsätzlich eine eigenständige Lösung der Aufgabe darstellt.

Zunächst und im Wesentlichen wird eine Halteeinrichtung vorgeschlagen, die an einem oberen Abschnitt des Gehäuses befestigt ist. Es handelt sich um eine temperaturstabilisierbare bzw. mechanisch stabilisierte Halteeinrichtung. An dieser formstabilisierten Halteeinrichtung ist das Gaseinlassorgan an einer Vielzahl von Aufhängestellen befestigt. Die Aufhängestellen sind im Wesentlichen gleichmäßig über die gesamte Erstreckungsfläche des Gaseinlassorgans verteilt. Der Abstand der Aufhängestellen voneinander ist mindestens um einen Faktor 3, bevorzugt aber um einen Faktor 4 oder um einen Faktor 5, geringer als die diagonale Erstreckung des Gaseinlassorgans. Besonders bevorzugt ist ein maximaler Abstand zweier benachbarter Aufhängestellen, der maximal ein Zehntel der diagonalen Erstreckung des Gaseinlassorganes betragen darf. Zur mechanischen Stabilisierung kann die Halteeinrichtung mechanische Stabilisierungselemente aufweisen. Diese mechanischen Stabilisierungselemente können von Vertikalwänden ausgebildet sein. Die Halteeinrichtung bildet bevorzugt ein Fachwerk aus, das von sich kreuzenden Vertikalwänden gebildet ist. Der Abstand zweier vertikal und gegebenenfalls auch parallel zueinander verlaufender Vertikalwände ist um mindestens einen Faktor 3, einen Faktor 4, bevorzugt aber einen Faktor 5, geringer als die Diagonalstrecke des Gaseinlassorgans. Es bilden sich in Vertikalrichtung erstreckende zylinderförmige Zellen aus mit einer Grundfläche, die bevorzugt maximal einem Hundertstel der Grundfläche des Gaseinlassorganes entspricht und einen schachbrettartigen oder bienenwabenartigen Grundriss besitzen können. Die Halteeinrichtung ist bevorzugt ausschließlich mit einer an ihren horizontalen Rand angrenzenden Bereich am Gehäuse befestigt. Es ist der horizontale Rand der Halteeinrichtung, der mit dem Gehäuse befestigt ist. Der gesamte zentrale Flächenabschnitt der Halteeinrichtung überspannt frei das Gaseinlassorgan, besitzt aber an einer Vielzahl von im Wesentlichen gleichmäßig über die Fläche verteilten Stellen eine haltende Verbindung zum Gaseinlassorgan. Die Halteeinrichtung ist temperaturstabilisiert. Hierzu kann eine aktive oder eine passive Temperaturstabilisierungsvorrichtung vorgesehen sein. Die Halteeinrichtung ist derart temperaturstabilisiert, dass sich ihre Temperatur weder in Horizontalrichtung noch in Vertikalrichtung signifikant ändert, wenn sich die Temperaturdifferenz zum Gaseinlassorgan ändert. Bevorzugt variiert die Temperatur innerhalb des gesamten von der Halteeinrichtung gebildeten Körpers, also bevorzugt dem Fachwerk um +/-5 Grad. Bevorzugt beträgt die Temperaturdifferenz zwischen dem kältesten Punkt und dem heißesten Punkt maximal 5 Grad. Zur passiven Temperaturstabilisierung können Wärmeschutzschilde, beispielsweise mit reflektierenden Oberflächen oder Isolierkörper vorgesehen sein. Zur aktiven Temperaturstabilisierung können Temperiermedien verwendet werden, beispielsweise Temperierflüssigkeiten, die durch Temperierkanäle hindurchströmen. Die Temperierkanäle können innerhalb der Halteeinrichtung angeordnet sein. Bevorzugt sind die Temperierkanäle aber oberhalb bzw. unterhalb der Halteeinrichtung vorgesehen. Muss die Halteeinrichtung zur Temperierung gekühlt werden, weil die Temperatur des Gaseinlassorgans während des Beschichtungsprozesses auf einer hohen Temperatur gehalten wird, so wird bevorzugt ein aktives Temperierelement verwendet, welches im Bereich zwischen Gaseinlassorgan und Halteeinrichtung angeordnet ist. Die wabenartige oder kastenartige Struktur der Halteeinrichtung, die ihr die Form eines Fachwerks verleiht, führt darüber hinaus zu einer mechanischen Stabilisierung. Dies hat auch zur Folge, dass eine sich bei einer Binnendruckänderung eventuell einstellende Formveränderung des Gehäuseoberteils die Form der Halteeinrichtung unbeeinflusst lässt. Bei den Befestigungsmitteln kann es sich um elastische Befestigungsmittel handeln, mit denen der Randbereich der Halteeinrichtung am Gehäuse befestigt ist. In einer bevorzugten Ausgestaltung erstreckt sich zwischen dem Gaseinlassorgan und der Halteeinrichtung ein vertikaler Abstandsraum. Zur Befestigung des Gaseinlassorgans an der Halteeinrichtung dient eine Vielzahl von Hängern. Bei den Hängern kann es sich um langgestreckte metallische oder keramische Zugelemente handeln, die mit ihrem oberen Ende an der Halteeinrichtung und mit ihrem unteren Ende an einer Befestigungsstelle des Gaseinlassorgans befestigt sind. Die Hänger können höheneinstellbar sein. Hierdurch lässt sich an jeder Aufhängestelle der Abstand zwischen Gasaustrittsfläche und Suszeptoroberseite, also die Prozesskammerhöhe einstellen. Bevorzugt sind die Hänger aus einem Material gefertigt, welches einen geringen thermischen Ausdehnungskoeffizienten besitzt. Die Wände des Gaseinlassorgans sind mit Temperierungskanälen versehen. Insbesondere ist die, die Gasaustrittsfläche ausbildende Wand des Gaseinlassorgans aber auch die davon wegweisende Wand mit Kanälen versehen, durch die ein Temperierungsmittel, beispielsweise eine heiße Flüssigkeit strömen kann. Zur Temperaturstabilisierung der Halteeinrichtung trägt nicht nur ihre Form bei. Die Halteeinrichtung ist als Leichtbauteil ausgebildet. Die Maßnahmen, die ergriffen werden, um den Wärmetransport vom Gaseinlassorgan zur Halteeinrichtung aktiv zu vermindern, können die Anordnung ein oder mehrere Wärmeschilde im Abstandsraum zwischen Gaseinlassorgan und Halteeinrichtung umfassen. Bei den Wärmeschilden handelt es sich um Flächenobjekte, die sich parallel zur Flächenerstreckung des Gaseinlassorgans im Abstandsraum befinden. Ihre Oberflächen können hochreflektierend sein. Alternativ dazu können auch Isolierkörper im Abstandsraum angeordnet sein. Zumindest ein Wärmeschild kann aktiv gekühlt werden. Das aktiv gekühlte Wärmeschild ist bevorzugt der Halteeinrichtung unmittelbar benachbart. Bei dem aktiv gekühlten Wärmeschild kann es sich um eine Platte handeln, deren Flächenerstreckung etwa der Flächenerstreckung der Halteeinrichtung bzw. der Flächenerstreckung des Gaseinlassorgans entspricht. Innerhalb der Platte verlaufen Kühlmittelkanäle, durch die ein Kühlmittel hindurchströmen kann. Hierdurch kann die Halteeinrichtung auf einer konstanten Temperatur gehalten werden. Wird das Gaseinlassorgan aufgeheizt, so behält die Halteeinrichtung im Wesentlichen ihre Temperatur bei. Die Strecke, um die sich die Prozesskammerhöhe während des Betriebs der Vorrichtung ändern kann, liegt bei unter 1 mm. Die Oberflächentemperatur des Gehäuses liegt bei etwa 30° C. Die Temperatur der Halteeinrichtung kann auf einen Wert von 50° C stabilisiert werden. Hierzu wird der aktive Wärmeschild auf eine Temperatur von etwa 50° gekühlt. Der Showerhead wird bei einer Temperatur von beispielsweise 450° betrieben und das Substrat auf eine Temperatur von 20° abgekühlt. Durch ein oder mehrere passive Wärmeschilde, die sich zwischen dem aktiven Wärmeschild und dem Gaseinlassorgan befinden, wird der Wärmefluss vom Gaseinlassorgan zum aktiv gekühlten Wärmeschild reduziert. Ein unmittelbar dem Gaseinlassorgan benachbartes Wärmeschild kann beispielsweise eine Oberflächentemperatur von 350° aufweisen. Das Wärmeschild kann aus Metall oder einem keramischen Werkstoff bestehen. Zwischen diesem passiven Wärmeschild und dem aktiven Wärmeschild kann ein weiteres passives Wärmeschild angeordnet sein, welches ebenfalls von einer Metallplatte oder einer Keramikplatte gebildet ist. Dessen Temperatur liegt beim Betrieb bei etwa 270° C. Es können auch mehr als zwei passive Wärmeschilde zwischen dem Gaseinlassorgan und dem aktiv gekühlten Wärmeschild vorgesehen sein. Die Oberflächen der Wärmeschilde können eine geringe optische Emissivität besitzen. Sie können polierte, spiegelnde Oberflächen sein. Die Hänger können verwendet werden, um die Wärmeschilde zu halten. Es ist aber auch vorgesehen, dass die Hänger lediglich durch Öffnungen der Wärmeschilde hindurchragen, so dass sich eine Verformung der Wärmeschilde nicht auf die Lage des Gaseinlassorgans im Raum auswirkt. Erfindungsgemäß ist die Halteeinrichtung gegen Verformungen stabilisiert. Es handelt sich dabei um Verformungen, die von einer sich ändernden Temperatur und/oder von einem sich ändernden Druck hervorgerufen werden. Die Wärmeschilde können an separaten Aufhängevorrichtungen aufgehangen sein, die entweder an der Gehäusedecke oder an der Halteeinrichtung befestigt sind. Die Erfindung betrifft darüber hinaus ein Verfahren zum Betrieb einer derartigen Vorrichtung. Die Erfindung betrifft insbesondere eine CVD- oder PVD-Vorrichtung mit einem Gehäuse, mit einer an einem oberen Abschnitt des Gehäuses befestigten Halteeinrichtung und einem temperierbaren Gaseinlass mit einer Gasaustrittsöffnungen aufweisenden Gasaustrittsfläche, welches Gaseinlassorgan an einer Vielzahl von Aufhängestellen an der Halteeinrichtung befestigt ist. Die Halteeinrichtung ist durch eine aktiv temperierbare Temperiereinrichtung temperaturstabilisierbar. Wesentlich ist, dass die Temperiereinrichtung bezogen auf eine Vertikalrichtung zwischen dem Gaseinlassorgan und der Halteeinrichtung angeordnet ist. Die Erfindung betrifft ferner eine CVD- oder PVD-Beschichtungseinrichtung mit einem Gehäuse, mit einer an einem oberen Abschnitt des Gehäuses befestigten Halteeinrichtung und einem Gaseinlassorgan mit einer Gasaustrittsöffnungen aufweisenden Gasaustrittsfläche, welches Gaseinlassorgan an einer Vielzahl von Aufhängestellen an der Halteeinrichtung befestigt ist. Wesentlich ist, dass die Halteeinrichtung eine Zellstruktur aufweist. Die Zellstruktur besitzt sich in Vertikalrichtung erstreckende Zellwände und eine horizontale Zellenfläche, die maximal ein Fünfundzwanzigstel, bevorzugt maximal rein Hundertstel der Grundfläche der Halteeinrichtung beträgt.

Ausführungsbeispiele der Erfindung werden nachfolgend anhand beigefügter Zeichnungen erläutert. Es zeigen:
- Fig. 1: einen Schnitt entlang der Linie I - I in Figur 2 durch eine schematisch dargestellte PVD-Beschichtungseinrichtung,
- Fig. 2: die Draufsicht auf die Beschichtungseinrichtung,
- Fig. 3: den Schnitt gemäß der Linie III - III in Figur 1,
- Fig. 4: das Gehäuseoberteil eines PVD-Reaktors eines zweiten Ausführungsbeispiels in einer Schnittdarstellung etwa gemäß Figur 1 und
- Fig. 5: das geschnittene Gehäuseoberteil gemäß Figur 4 in einer perspektivischen Darstellung.

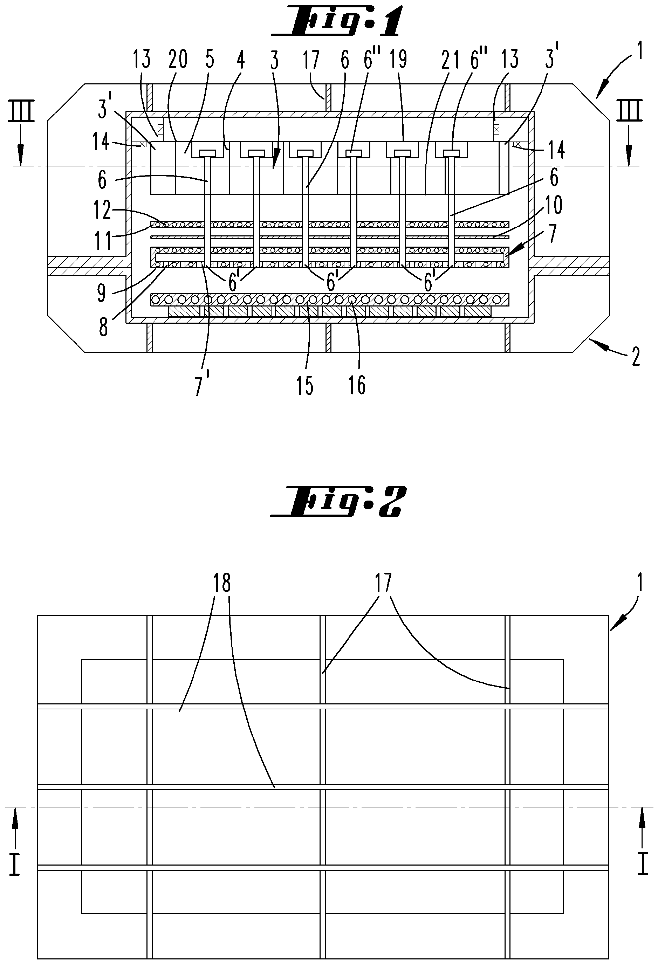

Die in den Figuren 1 bis 3 dargestellte Vorrichtung ist eine PVD-Vorrichtung zum Beschichten großflächiger Substrate mit organischen Schichten. Die Substrate können eine Rechteckform aufweisen mit einer Diagonalen von mehr als 1 m, vorzugsweise von mehr als 2 m oder 3 m. Das Gehäuseunterteil 2 trägt einen Suszeptor 15 zur Auflage des Substrates. Der Suszeptor 15 besitzt eine Vielzahl von Kühlmittelkanälen 16, durch die ein Kühlmittel in die Prozesskammer eingebracht werden kann. Der Suszeptor wird mittels des Kühlmittels auf einer Temperatur von etwa 20° C gehalten.

Der obere Teil 1 des Gehäuses besitzt eine Gehäusedecke, die von einer Rippenstruktur 17,18 mechanisch stabilisiert wird. Das Gehäuseunterteil 2 besitzt eine ähnliche Rippenstruktur zur mechanischen Stabilisierung des Gehäusebodens. In der Gehäusedecke können Temperiermittelkanäle angeordnet sein, durch die ein flüssiges Temperiermedium fließt, um die Gehäusedecke auf einer vorgegebenen Temperatur zu halten.

Am Rand der Gehäusedecke und am Rand der Seitenwandung des Gehäuseoberteils 1 sind Befestigungsmittel 13,14 vorgesehen. Es handelt sich um elastische Befestigungsmittel 13,14, mit denen eine Halteeinrichtung 3 an ihrem horizontalen Rand am Gehäuseoberteil 1 befestigt ist.

Die Halteeinrichtung 3 ist ein Leichtbauteil in Form eines Fachwerks oder einer Wabenstruktur. Es besitzt eine Vielzahl entlang vertikaler Verbindungslinien miteinander verbundener Flächenelemente 4, 5. Die Flächenelemente 4, 5 bilden Vertikalwände aus. Beim Ausführungsbeispiel wird die Halteeinrichtung 3 von einem sich kreuzende Vertikalwände 4, 5 ausbildenden Halterahmen ausgebildet, der mit seinem Rand 3' über die Befestigungsmittel 13, 14 am Gehäuse 1 befestigt ist. Da die Halteeinrichtung 3 nur an ihrem Rand 3' mit dem Gehäuse 1 befestigt ist, führt eine bei einer Druckänderung im Inneren des Gehäuses 1, 2 nicht zu vermeidenden Verbiegung der Gehäusedecke zu keiner relevanten Lageveränderung der Halteeinrichtung 3 innerhalb des Gehäuses 1, 2. Der gesamte vom Rand 3' umgebene mittlere Flächenbereich der Halteeinrichtung 3 unterspannt frei die dazu parallel verlaufende Deckenwandung des Gehäuseoberteils 1. Die Befestigungsmittel 13, 14 sind am Rand der Deckenwand des Gehäuseoberteils 1 befestigt. Die Halteeinrichtung 3 bildet eine offene oder geschlossene Zellstruktur aus, wobei die horizontalen Flächen der Zellen um mindestens den Faktor 100 kleiner sind als die Horizontalfläche der Halteeinrichtung 3. Die vertikale Höhe einer Fläche kann in der Größenordnung einer kreisäquivalenten Diagonalen der Horizontalfläche der Zelle liegen.

Ein Gaseinlassorgan 7, bei dem es sich um einen Hohlkörper handelt, dessen Wände Temperierkanäle 9 aufweisen, ist vertikal oberhalb des Suszeptors 15 angeordnet. Der Abstand der Unterseite des Gaseinlassorgans 7, die eine Gasaustrittsfläche 7' ausbildet, zur Oberseite des Suszeptors 15 beträgt wenige Zentimeter. Die Gasaustrittsfläche 7' besitzt eine Vielzahl von duschkopfartig angeordneten Gasaustrittsöffnungen 8, durch die aus dem Hohlraum des Gaseinlassorgans 7 Prozessgase in die Prozesskammer strömen können, die von der Oberseite des Suszeptors 15 und der Unterseite des Gaseinlassorgans 7 gebildet ist. Das Gaseinlassorgan 7 wird auf Temperaturen von etwa 450° C temperiert.

Das Gaseinlassorgan 7 ist mit mechanischen Befestigungselementen 6 an der Halteeinrichtung 3 befestigt. Die mechanischen Befestigungselemente 6 sind im Wesentlichen gleichmäßig über die gesamte Erstreckungsfläche des Gaseinlassorgans 7 verteilt angeordnet. Die Abstände benachbarter Befestigungselemente 6 voneinander sind wesentlich geringer als eine Kantenlänge oder die Diagonale des Gaseinlassorgans 7. Bevorzugt beträgt der maximale Abstand, den zwei benachbarte Befestigungselement 6 besitzen weniger als der zehnte Teil der kreisäquivalenten Diagonalen des Gaseinlassorgans.

Bei den mechanischen Befestigungselementen handelt es sich um Hänger 6, die mit einem Kopf 6' an der Halteeinrichtung 3 befestigt sind und sich über einen vertikalen Abstandsraum zum Gaseinlassorgan 7 erstrecken. Dort sind die Hänger 6 an Aufhängestellen 6' mit ihren Füßen am Gaseinlassorgan 7 befestigt. Das Gaseinlassorgan 7 besitzt zwei parallel zueinander sich erstreckende Wände, die jeweils Temperiermittelkanäle 9 aufweisen. Die Befestigungsstellen 6' können an der oberen Wandung des Gaseinlassorgans 7 vorgesehen sein. Beim Ausführungsbeispiel sind die Befestigungsstellen 6' aber an der die Gasaustrittsöffnungen 8 aufweisenden Wandung des Gaseinlassorgans 7 vorgesehen. Die Füße der Hänger 6 sind dort also an der untersten Wand des Gaseinlassorganes 7 befestigt.

Die Köpfe 6" der Hänger 6 sind in Öffnungen bzw. Aussparungen 19 der Oberseite der Halteeinrichtung 3 gelagert. Die Köpfe 6" können von Schrauben gebildet sein, die in Gewinde eingedreht sind, so dass sich über eine Drehung der Köpfe 6" die Länge der Hänger 6 bzw. die vertikale Position der Aufhängestellen 6' ändern lässt. Die Köpfe 6" können aber auch von Muttern oder anderen Einstellgliedern ausgebildet sein, mit denen sich die Höhenlage des Gaseinlassorgans lokal einstellen lässt. Hierdurch kann die Höhe der Prozesskammer örtlich voreingestellt werden. Die Hänger 6 bestehen bevorzugt aus einem Werkstoff, der nur einen geringen Wärmeausdehnungskoeffizienten aufweist, so dass sich die Erwärmung der Hänger 6 nicht auf die lokale Höhe der Prozesskammer auswirkt.

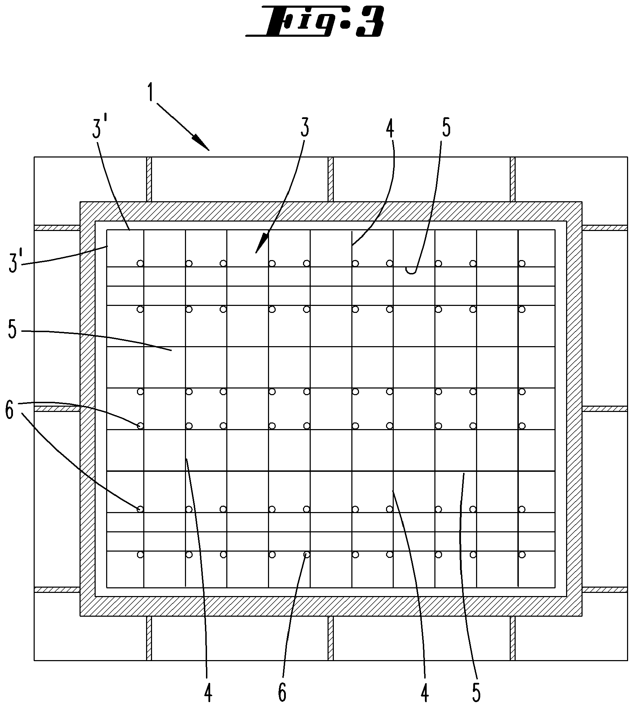

In einer bevorzugten Ausgestaltung, die auch in dem in den Figuren 1 und 3 dargestellten Ausführungsbeispiel verwirklicht ist, handelt es sich bei der Halteeinrichtung 3 nicht nur um einen mechanisch stabilisierten Halterahmen, sondern auch um einen temperaturstabilisierten Halterahmen. Hierzu befindet sich unmittelbar unterhalb der Halteeinrichtung 3 ein aktiv temperierter Wärmeschild 11. Bei dem Wärmeschild 11 handelt es sich um eine Platte aus Metall oder aus Keramik mit Kühlmittelkanälen 12. Durch diese Kühlmittelkanäle 12 wird ein Kühlmittel hindurchgeleitet, was den aktiv gekühlten Wärmeschild 11 auf eine Temperatur von etwa 50° bringt.

Zwischen dem aktiv gekühlten Wärmeschild 11 und dem Gaseinlassorgan 7 können ein oder mehrere passive Wärmeschilde angeordnet sein. Beim Ausführungsbeispiel ist ein passiver Wärmeschild 10 vorgesehen, bei dem es sich ebenfalls um eine Metallplatte oder um eine keramische Platte handeln kann. Der passive Wärmeschild besitzt eine Temperatur, die im Bereich zwischen der Temperatur des Gaseinlassorgans und der Temperatur des aktiven Wärmeschildes liegt. Die Temperatur des passiven Wärmeschildes kann im Bereich zwischen 400° und 200° liegen. Bei der Verwendung von mehreren parallel zueinander angeordneten passiven Wärmeschilden können die einzelnen Wärmeschilde Temperaturen von 270° bzw. 350° aufweisen. Die Temperatur der Halteeinrichtung wird dadurch auf etwa 50° gehalten. Die Gehäusetemperatur liegt dann bei etwa 30° C. Die passiven Wärmeschilde 10 sind vorzugsweise Metallplatten mit hochreflektierenden Oberflächen. Ihr Emissionskoeffizient liegt bei weniger als 0,2.

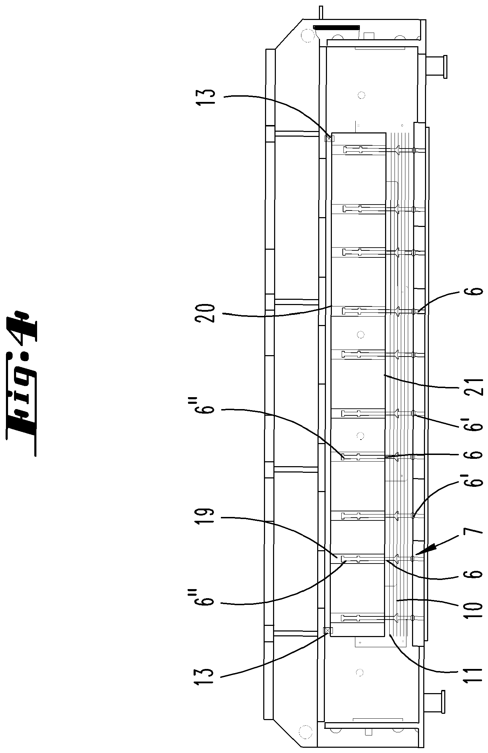

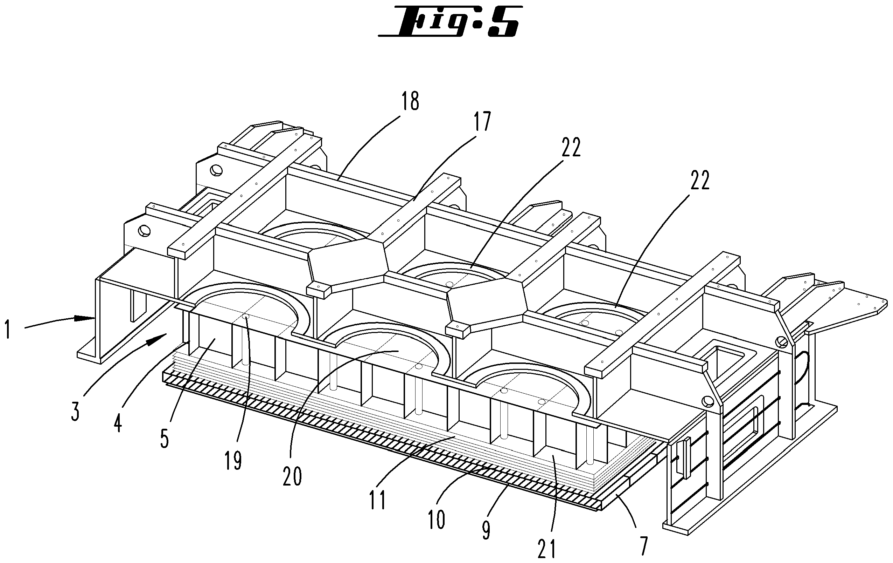

Das in den Figuren 4 und 5 dargestellte zweite Ausführungsbeispiel eines Gehäuseoberteiles 1 weist ebenfalls einen als Leichtbauteil ausgebildeten Halterahmen 3 aus, der von einer fachwerkartigen Kammerstruktur ausgebildet ist, wobei vertikale Kammerwände 4, 5 an vertikalen Verbindungslinien miteinander verbunden sind. Die Kammerwände 4, 5 können auch hier von dünnen Metallplatten ausgebildet sein. Zusätzlich weist dort der Halterahmen 3 noch eine horizontal verlaufende obere Horizontalwand 20 und eine untere Horizontalwand 21 auf.

Auch bei diesem Ausführungsbeispiel ist lediglich der vertikale umlaufende Rand 3' der Halteeinrichtung 3 mit dem Gehäuse 1 verbunden. Die diesbezüglichen Befestigungsmittel 13 können elastische Befestigungsmittel sein. Sämtliche Wände der Halteeinrichtung 3 bestehen aus dünnsten Flächenmaterialien, wie Blechen. Es bildet sich eine offen- oder geschlossenzellige Raumstruktur aus. Die Halteeinrichtung 3 ist am Rand einer Deckenplatte des Gehäuseoberteils 1 befestigt.

Ein Gaseinlassorgan 7 mit einer Vielzahl von Gasaustrittsöffnungen ist über eine Vielzahl von im Wesentlichen gleichmäßig über die Erstreckungsfläche des Gaseinlassorgans 7 angeordneten Befestigungsstellen 6' an der Halteeinrichtung 3 befestigt. Es sind mechanische Befestigungselemente 6 verbunden, die auch hier von Hängern gebildet sind. Der Kopf der Hänger 6" ist mit der Halteeinrichtung 3 verbunden. Der Fuß der Hänger 6 ist an den Befestigungsstellen 6' mit dem Gaseinlassorgan 7 verbunden. Auch hier befinden sich im vertikalen Abstandsraum zwischen der Halteeinrichtung 3 und dem Gaseinlassorgan 7 mehrere Wärmeschutzschilde 10,11. Auch hier ist zumindest ein aktiv gekühltes Wärmeschutzschild 11 vorgesehen, welches unmittelbar unterhalb der Halteeinrichtung angeordnet ist und sich parallel zur Unterseite der Halteeinrichtung 3 erstreckt. Zwischen dem aktiv gekühlten Wärmeschild 11 und der Oberseite des Gaseinlassorgans 7 erstreckt sich eine Vielzahl parallel zueinander verlaufender passiver Wärmeschutzschilde 10.

Bei dem Ausführungsbeispiel sind die Wärmeschutzschilde mit den Hängern 6 verbunden. Die Hänger 6 halten somit nicht nur das Gaseinlassorgan 7 an der Halteeinrichtung 3, sondern auch die Wärmeschutzschilde 10,11 in ihrer Vertikalposition. Die Wärmeschutzschilde 10,11 können aber auch mit gesonderten Hängern an der Halteeinrichtung 3 befestigt sein. Sie besitzen hochreflektierende Oberflächen. Eine unterhalb der Halteeinrichtung 3 angeordnete Platte 11, die sich über die gesamte Flächenerstreckung der Halteeinrichtung 3 erstreckt, besitzt Kühlmittelkanäle 12, durch die Kühlwasser hindurchfließt.

In einem nicht dargestellten Ausführungsbeispiel kann vorgesehen sein, dass die Wärmeschutzschilde 10,11, deren vertikale Lage im Wesentlichen unkritisch ist, über gesonderte Aufhängevorrichtungen direkt am Gehäuse 1 befestigt sind. Diesbezügliche Aufhängevorrichtungen können am Rand der Wärmeschutzschilde 10,11 vorgesehen sein. Sie können aber auch im mittleren Flächenbereich der Wärmeschutzschilde 10,11 vorgesehen sein und beispielsweise durch Durchtrittsöffnungen der Halteeinrichtung 3 hindurchgreifen, um an der Decke des Gehäuseoberteils 1 befestigt zu sein.

Im Deckelabschnitt des Gehäuseoberteiles 1 sind verschließbare Öffnungen 22 im Bereich zwischen den Versteifungsrippen 17,18 angeordnet. Durch Öffnen dieser Öffnungen 22 ist ein Zugang zur Oberseite der Halteeinrichtung 3 bzw. zur oberen Horizontalwand 20 möglich. Dort befinden sich die Öffnungen 19, in denen die Köpfe 6" der Hänger 6 stecken. Die Köpfe 6" können von Gewindeteilen ausgebildet sein, so dass sich durch Drehen der Köpfe 6" die effektive Länge der Hänger 6 beeinflussen lässt. Die Kopfe 6" der Hänger bilden somit Einstellorgane, um lokal die Höhe der Prozesskammer, also den Abstand des Gaseinlassorgans 7 vom Suszeptor 15 zu beeinflussen.

Die zuvor beschriebene Vorrichtung wird verwendet, um OLEDs auf großflächigen Substraten abzuscheiden. Bei diesem Verfahren werden feste, in Pulverform vorliegende Ausgangsstoffe über einen Verdampfer in eine Gasform gebracht. Mittels eines Trägergases wird der so gebildete organische Dampf in das Gaseinlassorgan 7 gefördert, wo der Dampf aus den Gasaustrittsöffnungen 7' heraustritt, um auf der Oberfläche eines auf dem Suszeptor 15 aufliegenden Substrates zu kondensieren.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, nämlich:
Eine CVD- oder PVD-Beschichtungseinrichtung, die gekennzeichnet ist durch eine aktiv temperierbare Temperiereinrichtung (11,12), mit der die Halteeinrichtung (3) temperaturstabilisierbar ist.

Eine CVD- oder PVD-Beschichtungseinrichtung, die dadurch gekennzeichnet ist, dass die Temperiereinrichtung (11, 12) Temperiermittelkanäle (12) aufweist.

Eine CVD- oder PVD-Beschichtungseinrichtung, die dadurch gekennzeichnet ist, dass die Temperiereinrichtung (11, 12) zwischen Gaseinlassorgan (7) und Halteeinrichtung (3) angeordnet ist.

Eine CVD- oder PVD-Beschichtungseinrichtung, die dadurch gekennzeichnet ist, dass die Halteeinrichtung mechanische Stabilisierungselemente aufweist.

Eine CVD- oder PVD-Beschichtungseinrichtung, die dadurch gekennzeichnet ist, dass die Halteeinrichtung von einem, an vertikalen Verbindungslinien miteinander verbundene Vertikalwände aufweisenden Halterahmen ausgebildet ist.

Eine CVD- oder PVD-Beschichtungseinrichtung, die dadurch gekennzeichnet ist, dass die Halteeinrichtung ausschließlich an ihrem horizontalen Rand am Gehäuse befestigt ist.

Eine CVD- oder PVD-Beschichtungseinrichtung, die dadurch gekennzeichnet ist, dass die Halteeinrichtung mit elastischen Befestigungsmitteln am Gehäuse befestigt ist.

Eine CVD- oder PVD-Beschichtungseinrichtung, die dadurch gekennzeichnet ist, dass das Gaseinlassorgan mit einer Vielzahl von über die gesamte horizontale Erstreckungsfläche verteilt angeordnete Hänger an der Halteeinrichtung befestigt ist, wobei sich die Hänger in Vertikalrichtung von den Aufhängestellen zur Halteeinrichtung erstrecken.

Eine CVD- oder PVD-Beschichtungseinrichtung, die dadurch gekennzeichnet ist, dass in einem vertikalen Abstandsraum zwischen Gaseinlassorgan und Halteeinrichtung ein oder mehrere Wärmeschilde angeordnet sind.

Eine CVD- oder PVD-Beschichtungseinrichtung, die dadurch gekennzeichnet ist, dass die Temperiereinrichtung (11) von einem der Wärmeschilde ausgebildet ist, welcher der Halteeinrichtung (3) unmittelbar benachbart ist.

Eine CVD- oder PVD-Beschichtungseinrichtung, die dadurch gekennzeichnet ist, dass zwei unmittelbar benachbarte Aufhängestellen maximal um ein Fünftel der kreisäquivalenten Diagonalen des Gaseinlassorgans voneinander beabstandet sind.

Eine CVD- oder PVD-Beschichtungseinrichtung, die dadurch gekennzeichnet ist, dass die Halteeinrichtung eine Zellstruktur aufweist mit sich in Vertikalrichtung erstreckenden Zellwänden und einer horizontalen Zellenfläche, die maximal ein Fünfundzwanzigstel, bevorzugt maximal ein Hundertstel der Grundfläche der Halteeinrichtung beträgt.

Ein Verfahren zum Betrieb einer CVD- oder PVD-Beschichtungseinrichtung, welches dadurch gekennzeichnet ist, dass die Halteeinrichtung 3 mit Hilfe der Temperiereinrichtung 11,12 auf einer homogenen Temperatur gehalten wird, so dass sich der kälteste Punkt der Halteeinrichtung um maximal 5 Grad vom wärmsten Punkt der Halteeinrichtung unterscheidet.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen. Die Unteransprüche charakterisieren mit ihren Merkmalen eigenständige erfinderische Weiterbildungen des Standes der Technik, insbesondere um auf Basis dieser Ansprüche Teilanmeldungen vorzunehmen.

**Bezugszeichenliste**

| | | | | | |
|---|---|---|---|---|---|
| 1 | Gehäuseoberteil | | | | |
| 2 | Gehäuseunterteil | | | | |
| 3 | Halteeinrichtung | 3' | Rand | | |
| 4 | Vertikalwand | | | | |
| 5 | Vertikalwand | | | | |
| 6 | Befestigungselement | 6' | Aufhängestellen | 6" | Kopf |
| 7 | Gaseinlassorgen | 7' | Gasaustrittsfläche | | |
| 8 | Gasaustrittsöffnung | | | | |
| 9 | Temperierkanal | | | | |
| 10 | passives Wärmeschild | | | | |
| 11 | aktives Wärmeschild | | | | |
| 12 | Kühlmittelkanal | | | | |
| 13 | Befestigungsmittel | | | | |
| 14 | Befestigungsmittel | | | | |
| 15 | Suszeptor | | | | |
| 16 | Kühlmittelkanal | | | | |
| 17 | Rippe | | | | |
| 18 | Rippe | | | | |
| 19 | Öffnung | | | | |
| 20 | obere Horizontalwand | | | | |
| 21 | untere Horizontalwand | | | | |
| 22 | Öffnung | | | | |
| 23 | | | | | |
| 24 | | | | | |
| 25 | | | | | |

## Patentansprüche

1. CVD- oder PVD-Beschichtungseinrichtung mit einem Gehäuse (1, 2) und einem am Gehäuse (1, 2) befestigten Gaseinlassorgan (7) mit einer Gasaustrittsöffnungen (8) aufweisenden Gasaustrittsfläche (7'), mit einer an einem oberen Abschnitt des Gehäuses (1) befestigten Halteeinrichtung (3), an welcher das Gaseinlassorgan (7) an einer Vielzahl von Aufhängestellen (6') befestigt ist, wobei die Halteeinrichtung (3) mittels einer aktiv temperierbaren Temperiereinrichtung (11, 12), temperaturstabilisierbar ist, **dadurch gekennzeichnet, dass** die Temperiereinrichtung (11,12) als aktiv gekühltes Wärmeschild zwischen Gaseinlassorgan (7) und Halteeinrichtung (3) angeordnet ist.

2. CVD- oder PVD-Beschichtungseinrichtung nach Anspruch 1, **dadurch gekennzeichnet, dass** die Temperiereinrichtung (11, 12) Temperiermittelkanäle (12) aufweist.

3. CVD- oder PVD-Beschichtungseinrichtung nach einem der vorhergehenden Ansprüche, **dadurch gekennzeichnet, dass** die Halteeinrichtung (3) mechanische Stabilisierungselemente (4, 5) aufweist.

4. CVD- oder PVD-Beschichtungseinrichtung nach einem der vorhergehenden Ansprüche, **dadurch gekennzeichnet, dass** die Halteeinrichtung (3) von einem, an vertikalen Verbindungslinien miteinander verbundene Vertikalwände (4, 5) aufweisenden Halterahmen ausgebildet ist.

5. CVD- oder PVD-Beschichtungseinrichtung nach einem der vorhergehenden Ansprüche, **dadurch gekennzeichnet, dass** die Halteeinrichtung (3) ausschließlich an ihrem horizontalen Rand (3') am Gehäuse (1, 2) befestigt ist.

6. CVD- oder PVD-Beschichtungseinrichtung nach einem der vorhergehenden Ansprüche, **dadurch gekennzeichnet, dass** die Halteeinrichtung (3) mit elastischen Befestigungsmitteln (13,14) am Gehäuse (1, 2) befestigt ist.

7. CVD- oder PVD-Beschichtungseinrichtung nach einem der vorhergehenden Ansprüche, **dadurch gekennzeichnet, dass** das Gaseinlassorgan (7) mit einer Vielzahl von über die gesamte horizontale Erstreckungsfläche verteilt angeordnete Hängern (6) an der Halteeinrichtung (3) befestigt ist, wobei sich die Hänger (6) in Vertikalrichtung von den Aufhängestellen (6') zur Halteeinrichtung (3) erstrecken.

8. CVD- oder PVD-Beschichtungseinrichtung nach einem der vorhergehenden Ansprüche, **dadurch gekennzeichnet, dass** in einem vertikalen Abstandsraum zwischen Gaseinlassorgan (7) und Halteeinrichtung (3) ein oder mehrere weitere Wärmeschilde (10) angeordnet sind.

9. CVD- oder PVD-Beschichtungseinrichtung nach einem der vorhergehenden Ansprüche, **dadurch gekennzeichnet, dass** der von der Temperiereinrichtung (11) ausgebildete Wärmeschild der Halteeinrichtung (3) unmittelbar benachbart ist.

10. CVD- oder PVD-Beschichtungseinrichtung nach einem der vorhergehenden Ansprüche, **dadurch gekennzeichnet, dass** zwei unmittelbar benachbarte Aufhängestellen (6') maximal um ein Fünftel der kreisäquivalenten Diagonalen des Gaseinlassorgans (7) voneinander beabstandet sind.

11. CVD- oder PVD-Beschichtungseinrichtung nach einem der vorhergehenden Ansprüche, **dadurch gekennzeichnet, dass** die Halteeinrichtung (3) eine Zellstruktur aufweist mit sich in Vertikalrichtung erstreckenden Zellwänden (4, 5) und einer horizontalen Zellenfläche, die maximal ein Fünfundzwanzigstel, bevorzugt maximal ein Hundertstel der Grundfläche der Halteeinrichtung (3) beträgt.

12. Verfahren zum Betrieb einer CVD- oder PVD-Beschichtungseinrichtung gemäß einem der vorhergehenden Ansprüche, **dadurch gekennzeichnet, dass** die Halteeinrichtung (3) mit Hilfe der Temperiereinrichtung (11, 12) auf einer homogenen Temperatur gehalten wird, so dass sich der kälteste Punkt der Halteeinrichtung um maximal 5 Grad vom wärmsten Punkt der Halteeinrichtung unterscheidet.

## Claims

1. A CVD or PVD coating device with a housing (1, 2) and a gas inlet organ (7) that is secured to the housing (1, 2) and has a gas outlet surface (7') exhibiting gas outlet openings (8), with a retaining device (3) secured to an upper section of the housing (1), to which the gas inlet organ (7) is secured at a plurality of suspension points (6'), wherein the temperature of the retaining device (3) can be stabilized by means of an actively temperature controllable temperature control device (11, 12), **characterized in that** the temperature control device (11, 12) is arranged between the gas inlet organ (7) and retaining device (3) as an actively cooled heat shield.

2. The CVD or PVD coating device according to claim 1, **characterized in that** the temperature control device (11, 12) has temperature control medium channels (12).

3. The CVD or PVD coating device according to one of the preceding claims, **characterized in that** the retaining device (3) has mechanical stabilization elements (4, 5) .

4. The CVD or PVD coating device according to one of the preceding claims, **characterized in that** the retaining device (3) consists of a retaining frame exhibiting vertical walls (4, 5) interconnected at vertical connection lines.

5. The CVD or PVD coating device according to one of the preceding claims, **characterized in that** the retaining device (3) is secured to the housing (1, 2) exclusively at its horizontal edge (3').

6. The CVD or PVD coating device according to one of the preceding claims, **characterized in that** the retaining device (3) is secured to the housing (1, 2) with elastic fastening means (13, 14).

7. The CVD or PVD coating device according to one of the preceding claims, **characterized in that** the gas inlet organ (7) is secured to the retaining device (3) with a plurality of hangers (6) distributed over the entire horizontal extension surface, wherein the hangers (6) extend in the vertical direction from the suspension points (6') to the retaining device (3).

8. The CVD or PVD coating device according to one of the preceding claims, **characterized in that** one or several heat shields (10) are arranged in a vertical space between the gas inlet organ (7) and retaining device (3).

9. The CVD or PVD coating device according to one of the preceding claims, **characterized in that** the heat shield comprised of the temperature control device (11) is immediately adjacent to the retaining device (3).

10. The CVD or PVD coating device according to one of the preceding claims, **characterized in that** two immediately adjacent suspension points (6') are spaced apart from each other at most by one fifth of the circle equivalent diagonal of the gas inlet organ (7).

11. The CVD or PVD coating device according to one of the preceding claims, **characterized in that** the retaining device (3) has a cell structure with cell walls (4, 5) extending in a vertical direction and a horizontal cell surface, which measures at most one twenty fifth, preferably at most one hundredth, of the base area of the retaining device (3).

12. A method for operating a CVD or PVD coating device according to one of the preceding claims, **characterized in that** the retaining device (3) is kept at a homogenous temperature by means of the temperature control device (11, 12), so that the coldest point of the retaining device differs by at most 5 degrees from the warmest point of the retaining device.

## Revendications

1. Dispositif de revêtement CVD ou PVD, comprenant un boîtier (1, 2) et un organe d'entrée de gaz (7) fixé au boîtier (1, 2) et présentant une surface de sortie de gaz (7') ayant des ouvertures de sortie de gaz (8), et comprenant un dispositif de maintien (3) fixé à une partie supérieure du boîtier (1) et auquel l'organe d'entrée de gaz (7) est fixé à plusieurs points de suspension (6'), dans lequel le dispositif de maintien (3) peut être stabilisé en température au moyen d'un dispositif de régulation de température (11, 12) dont la température peut être régulée activement, **caractérisé en ce que** le dispositif de régulation de température (11, 12) est agencé en tant qu'écran thermique refroidi activement entre l'organe d'entrée de gaz (7) et le dispositif de maintien (3) .

2. Dispositif de revêtement CVD ou PVD selon la revendication 1, **caractérisé en ce que** le dispositif de régulation de température (11, 12) présente des canaux de fluide de régulation de température (12).

3. Dispositif de revêtement CVD ou PVD selon l'une des revendications précédentes, **caractérisé en ce que** le dispositif de maintien (3) présente des éléments mécaniques de stabilisation (4, 5).

4. Dispositif de revêtement CVD ou PVD selon l'une des revendications précédentes, **caractérisé en ce que** le dispositif de maintien (3) est formé par un cadre de maintien présentant des parois verticales (4, 5) reliées entre elles au niveau de lignes de liaison verticales.

5. Dispositif de revêtement CVD ou PVD selon l'une des revendications précédentes, **caractérisé en ce que** le dispositif de maintien (3) est fixé au boîtier (1, 2) exclusivement par son bord horizontal (3').

6. Dispositif de revêtement CVD ou PVD selon l'une des revendications précédentes, **caractérisé en ce que** le dispositif de maintien (3) est fixé au boîtier (1, 2) par des moyens de fixation élastiques (13, 14).

7. Dispositif de revêtement CVD ou PVD selon l'une des revendications précédentes, **caractérisé en ce que** l'organe d'entrée de gaz (7) est fixé au dispositif de maintien (3) avec une pluralité de suspentes (6) réparties sur l'ensemble de la surface d'extension horizontale, les suspentes (6) s'étendant dans la direction verticale depuis les points de suspension (6') au dispositif de maintien (3).

8. Dispositif de revêtement CVD ou PVD selon l'une des revendications précédentes, **caractérisé en ce qu'**un ou plusieurs autres écrans thermiques (10) sont agencés dans un espace d'écartement vertical entre l'organe d'entrée de gaz (7) et le dispositif de maintien (3).

9. Dispositif de revêtement CVD ou PVD selon l'une des revendications précédentes, **caractérisé en ce que** l'écran thermique formé par le dispositif de régulation de température (11) est directement adjacent au dispositif de maintien (3).

10. Dispositif de revêtement CVD ou PVD selon l'une des revendications précédentes, **caractérisé en ce que** deux points de suspension (6') immédiatement adjacents sont espacés l'un de l'autre d'au maximum un cinquième des diagonales d'équivalent de cercle de l'organe d'entrée de gaz (7).

11. Dispositif de revêtement CVD ou PVD selon l'une des revendications précédentes, **caractérisé en ce que** le dispositif de maintien (3) comprend une structure cellulaire avec des parois cellulaires (4, 5) s'étendant dans la direction verticale et une surface cellulaire horizontale qui correspond au maximum à un vingt-cinquième, de préférence au maximum à un centième, de la surface de base du dispositif de maintien (3).

12. Procédé pour faire fonctionner un dispositif de revêtement CVD ou PVD selon l'une des revendications précédentes, **caractérisé en ce que** le dispositif de maintien (3) est maintenu à une température homogène au moyen du dispositif de régulation de température (11, 12) de manière que le point le plus froid du dispositif de maintien diffère au maximum de 5 degrés du point le plus chaud du dispositif de maintien.
